(19) Europäisches Patentamt

European Patent Office

Office européen des brevets

(11) **EP 1 538 496 A2**

(12) **EUROPÄISCHE PATENTANMELDUNG**

(43) Veröffentlichungstag:
08.06.2005 Patentblatt 2005/23

(51) Int Cl.⁷: **G05B 19/00**, D21F 1/08

(21) Anmeldenummer: 04104808.3

(22) Anmeldetag: **30.09.2004**

(84) Benannte Vertragsstaaten:
**AT BE BG CH CY CZ DE DK EE ES FI FR GB GR HU IE IT LI LU MC NL PL PT RO SE SI SK TR**
Benannte Erstreckungsstaaten:
**AL HR LT LV MK**

(30) Priorität: **15.10.2003 DE 10347941**

(71) Anmelder: **ROBERT BOSCH GMBH**
**70442 Stuttgart (DE)**

(72) Erfinder: **Lay Fook, Yeoh**
**1170, Penang (MY)**

(54) **AM-Empfänger**

(57) Ein AM-Empfänger für amplitudenmodulierte Rundfunksignale mit einer Antennensignalvorstufe (1) und einem Mischer (8) zur Umsetzung des Antennensignals von Empfangsfrequenz auf eine höhere Zwischenfrequenz (ZF) hat zwischen der Antennensignalvorstufe (2) und dem Mischer (8) eine Abstimmschaltung (10), wobei die Abstimmschaltung (10) mit einer Abstimmspannung ($V_T$) in Abhängigkeit einer mit einem Digital-Analog-Wandler (12) aus für Empfangsfrequenzen definiert gespeicherten Werten gewonnen analogen Steuerspannung ($V_{DAC}$) und einer Feldstärkemessspannung ($V_{PLL}$) angesteuert ist.

Fig. 1

**Beschreibung**

Die Erfindung betrifft einen AM-Empfänger für amplitudenmodulierte Rundfunksignale mit einer Antennensignalvorstufe und einem Mischer zur Umsetzung des Antennensignals von der Empfangsfrequenz auf eine höhere Zwischenfrequenz.

Nach dem Prinzip der Aufwärtsmischung (Up-Conversion) arbeitende AM-Empfänger sind hinreichend bekannt. Die Aufwärtsmischung eines Empfangsfrequenzsignals von der Antenne auf eine höhere Zwischenfrequenz hat den Vorteil, dass insbesondere für Einchiplösungen wenig Komponenten erforderlich sind. Allerdings ist eine relativ aufwändige Abstimmschaltung bei solchen AM-Empfängern erforderlich, die herkömmlicherweise drei relativ teure Abstimmdioden und Trimmkapazitäten erfordern, um eine ausreichend genaue Frequenzauswahl zu erlauben. Dabei ist eine iterative Abstimmung der Trimmkapazitäten und Empfangsfrequenzspulen erforderlich, was einen höheren Herstellungsaufwand erfordert.

Ohne Ansteuerungsschaltung haben AM-Empfänger eine unzureichende Frequenzselektivität und Frequenzunterdrückungseigenschaften.

Aufgabe der Erfindung ist es daher, einen verbesserten AM-Empfänger zu schaffen, der eine kostengünstigere Abstimmschaltung hat, die nicht justiert werden muss.

Die Aufgabe wird mit dem gattungsgemäßen AM-Empfänger erfindungsgemäß dadurch gelöst, dass zwischen der Antennensignalvorstufe und dem Mischer eine Abstimmschaltung vorgesehen ist, wobei die Abstimmschaltung mit einer Abstimmspannung in Abhängigkeit einer mit einem Digital-Analog-Wandler aus für Empfangsfrequenzen definiert gespeicherten digitalen Werten gewonnenen analogen Steuerspannung und einer Feldstärkemessspannung angesteuert ist.

Durch die Steuerung der Abstimmschaltung mit definierten Werten, die für mögliche Empfangsfrequenzen in dem Empfänger abgespeichert sind und mit einer Anpassung dieser vordefinierten analogen Steuerspannung durch die Feldstärkemessspannung wird eine automatische Einstellung des AM-Empfängers erreicht.

Dabei sollte die Abstimmspannung proportional zur Differenz aus der Feldstärkemessspannung und der analogen Steuerspannung sein.

Die Feldstärkemessspannung kann beispielsweise eine Ausgangsspannung eines Phasenregelkreises PLL sein, der ohnehin in einem AM-Empfänger vorgesehen ist.

Die Abstimmschaltung hat vorzugsweise einen Übertrager und eine kapazitive Abstimmdiode, die zwischen einen Anschluss der Sekundärwicklung des Übertragers und einen Anschluss für die Abstimmspannung geklemmt ist. Die Kapazität der Abstimmdiode wird dann in Abhängigkeit von der Abstimmspannung verändert und auf diese Weise die Resonanzfrequenz des aus der Sekundärwicklung und der kapazitiven Abstimmdiode gebildeten Speicherschwingkreises eingestellt. Die Resonanzfrequenz f berechnet sich hierbei zu

$f = \dfrac{1}{2\pi\sqrt{(LC)}}$, wobei L die Induktivität der Sekundärwicklung und C die Kapazität der Abstimmdiode ist.

Die Sekundärwicklung und eine Reihenschaltung von Abstimmdiode und Kapazität können hierbei parallel mit einem Ende an Massepotential und dem anderen Ende an einen Verstärker geschaltet sein. Der Ausgang des Verstärkers wird dann über eine Entkopplungskapazität an den Mischer geklemmt.

Die Abstimmspannung wird vorzugsweise mit einer Operationsverstärkerschaltung derart erzeugt, dass der Digital-Analog-Wandler über einen ersten Widerstand an einen ersten Eingang eines mit seinem Ausgang über einen zweiten Widerstand an den ersten Eingang rückgekoppelten ersten Operationsverstärkers geschaltet ist. Am Ausgang des ersten Operationsverstärkers liegt dann die Abstimmspannung an. Die Feldstärkemessspannung ist an den ersten Eingang eines rückgekoppelten zweiten Operationsverstärkers gelegt, wobei der Ausgang des rückgekoppelten zweiten Operationsverstärkers über einen Widerstand an den zweiten Eingang des ersten Operationsverstärkers geklemmt ist. Mit dieser Schaltungsanordnung wird die Abstimmungsspannung proportional zum Verhältnis des ersten Widerstandes zum zweiten Widerstand und der Differenz aus analoger Steuerspannung und Feldstärkemessspannung

$$V_T = \frac{R_7}{R_6} \cdot (V_{DAC} - V_{PLL})$$

generiert.

Um auch weitere Frequenzbänder empfangen zu können, wie beispielsweise Mittelwellen- und Langwellensender, ist es vorteilhaft einen zweiten Übertrager zum Empfangen eines anderen Frequenzbandes mit seinen Primär- und Sekundärwicklungen jeweils seriell an die entsprechende Primär- und Sekundärwicklung des ersten Übertragers schaltbar anzuklemmen. Für den Mittelwellenempfang wird der zweite Übertrager abgeschaltet, indem beide Enden der Sekundärwicklung auf Massepotential gelegt werden.

Die Erfindung wird nachfolgend anhand der beigefügten Zeichnungen näher erläutert. Es zeigen:

Figur 1 -      Schaltbild eines erfindungsgemäßen AM-Empfängers zum Mittelwellenempfang;

Figur 2 -      Schaltbild eines erfindungsgemäßen AM-Empfängers zum Mittelwellen- und Langwellenempfang.

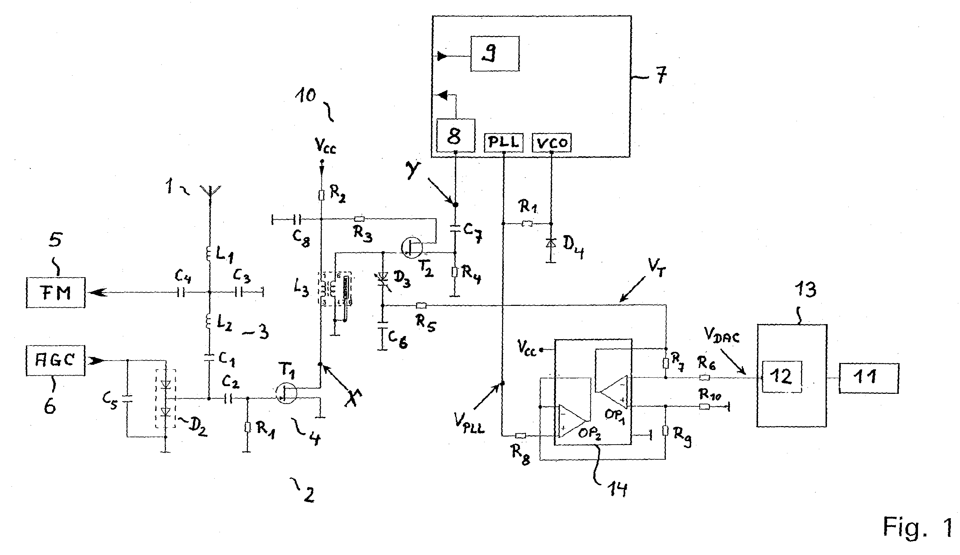

Die Figur 1 lässt ein Schaltbild eines erfindungsgemäßen AM-Empfängers für amplitudenmodulierte Rundfunksignale erkennen, die über eine Antenne 1 mit einer Induktivität $L_1$ in die Antennensignalvorstufe 2 des AM-Empfängers eingekoppelt werden. Die Antennensignalvorstufe 2 hat einen Bandpassfilter 3, der aus der Serienschaltung einer Induktivität $L_2$ und einer Kapazität $C_1$ gebildet ist. An den Ausgang des Bandpassfilters 3 ist über einen Koppelkondensator $C_2$ ein Antennensignalverstärker 4 geschaltet, der aus einem FET-Transistor $T_1$ und einem Basiswiderstand $R_1$ gebildet ist. Das Antenneneingangssignal kann weiterhin über Koppelkondensatoren $C_3$ und $C_4$ an einen FM-Empfänger 5 geleitet werden. Weiterhin kann an dem Ausgang des Bandpassfilters 3 eine automatische Verstärkungsregelung (Automatic- Gain-Control AGC) 6 für den AM-Empfänger vorgesehen sein, die über eine Diodenschaltung $D_2$ und eine Kapazität $C_5$ eingesteuert wird.

Der AM-Empfänger hat weiterhin in bekannter Weise einen integrierten Empfangsschaltkreis 7 zur AM-Aufwärtsregelung mit einem ersten Mischer 8 und einem Phasenregelkreis PLL zur Synchronisation einer Empfangsfrequenz durch eine Referenzfrequenz, der durch einen spannungsgesteuerten Oszillator VCO angesteuert wird. Der Phasenregelkreis PLL ist eingerastet, wenn die Oszillatorfrequenz VCO und eine Vergleichsfrequenz phasenstarr synchronisiert sind.

Weiterhin ist ein zweiter AM-Mischer 9 vorgesehen.

Erfindungsgemäß ist nun zwischen die Punkte X und Y am Ausgang X des Antennensignalverstärkers 4 und am Eingang Y des ersten Mischers 8 im integrierten Empfangsbaustein 7 eine Abstimmschaltung 10 eingebaut. Die Abstimmschaltung 10 besteht im Wesentlichen aus einem Übertrager $L_3$, dessen Sekundärwicklung über einen Widerstand $R_2$ an eine Versorgungsspannung $V_{CC}$ sowie an den Ausgang des Antennensignalverstärkers 4 am Punkt X geklemmt ist, sowie einer kapazitiven Abstimmdiode $D_3$ deren Kapazität in Abhängigkeit von einer Abstimmspannung $V_T$ eingestellt werden kann. Die Sekundärwicklung des Übertragers $L_3$ ist parallel zu der kapazitiven Abstimmdiode $D_3$ und einer Kapazität $T_6$ an Masse GND sowie an den Eingang eines Abstimmverstärkers geschaltet, der aus einem FET-Transistor $T_2$ gebildet ist. Die Sekundärwicklung des Übertragers $L_3$ und die kapazitive Abstimmdiode $D_3$ bilden einen Energiespeicher. Der Ausgang des Abstimmverstärkers $T_2$ ist über eine Entkopplungskapazität $C_7$ am Punkt Y an den Eingang des ersten Mischers geklemmt. Weiterhin sind Widerstände $R_3$ und $R_4$ an dem Kollektor und Emitter des Abstimmtransistors $T_2$ vorgesehen. Weiterhin ist die Primärwicklung des Übertragers $L_3$ über eine Entkopplungskapazität $C_8$ an Massepotential GND geschaltet.

Die Abstimmspannung $V_T$ wird über einen Widerstand $R_5$ an der Kathode der kapazitiven Abstimmdiode $D_3$ angelegt.

Erfindungsgemäß wird die Abstimmspannung $V_T$ in Abhängigkeit von einer bezogen auf eine jeweils ausgewählte Empfangsfrequenz festgelegte gespeicherte Spannung $V_{DAC}$ erzeugt. Hierzu sind Spannungswerte für Empfangsfrequenzen in einem Festspeicher 11, beispielsweise einem EEPROM abgelegt. So können Spannungswerte für die Frequenzen 522, 530,630,720,810,900,990,1080,1170,1260,1350,1440, 1530,1620 und 1710 kHz abgespeichert werden. Für eine Abstimmung des AM-Empfängers auf Frequenzen, die jeweils zwischen zwei der genannten Frequenzen liegen, wird eine lineare Interpolation durchgeführt. Zur Erzeugung der analogen Steuerspannung $V_{DAC}$ ist ein Digital-Analog-Wandler 12 vorgesehen, der über einen Mikrocontroller 13 angesteuert wird. Der Mikrocontroller 13 liest den in dem Festspeicher 11 abgelegten Spannungswert für eine ausgewählte Frequenz aus und berechnet beispielsweise durch lineare Interpolation einen erforderlichen Wert, um eine entsprechende analoge Steuerspannung $V_{DAC}$ durch den Digital-Analog-Wandler 12 zu erzeugen.

Die analoge Steuerspannung $V_{DAC}$ wird über einen Widerstand $R_6$ an einen ersten Eingang eines Operationsverstärkers $OP_1$ gelegt. Der erste Operationsverstärker $OP_1$ ist mit seinem Ausgang über einen zweiten Widerstand $R_7$ an den ersten Eingang rückgekoppelt. Am Ausgang des ersten Operationsverstärkers $OP_1$ liegt die Abstimmspannung $V_T$ an.

Ein zweiter Operationsverstärker $OP_2$ ist mit seinem Ausgang ebenfalls an den ersten Eingang des zweiten Operationsverstärkers $OP_2$ rückgekoppelt. An dem zweiten Eingang liegt über einen Widerstand $R_8$ eine Feldstärkemessspannung $V_{PLL}$ an, die von dem Phasenregelkreis $P_{LL}$ zur Verfügung gestellt wird. Der Ausgang des zweiten Operationsverstärkers $OP_2$ ist über einen Widerstand $R_9$ an den zweiten Eingang des ersten Operationsverstärkers $OP_1$ geschaltet, der über einen weiteren Widerstand $R_C$ mit Massepotential GND verbunden ist. Der erste und zweite Operationsverstärker $OP_1$ und $OP_2$ sind vorzugsweise in einem integrierten Verstärkerschaltkreis 14 realisiert, der mit einer Versorgungsspannung $V_{CC}$ betrieben wird.

Durch diese Operationsverstärker-Schaltung wird die Abstimmspannung $V_T$ proportional zur Differenz der Feldstärkemessspannung $V_{PLL}$ und der festgelegten analogen Steuerspannung $V_{DAC}$ gemäß der Gleichung

$$V_T = \frac{R_7}{R_6} \cdot (V_{PLL} - V_{DAC})$$

erzeugt. Die Feldstärkemessspannung $V_{PLL}$ hängt von der Mittelwellenfrequenz ab. Durch die Berücksichtigung der Feldstärkemessspannung $V_{PLL}$ wird eine bessere Temperaturstabilität erhalten, indem die Temperaturdrift insbesondere der Speicherschaltung aus Übertrager $L_3$ und kapazitiver Abstimmdiode $D_3$ kompensiert wird.

Die integrierte Verstärkerschaltung 14 sollte im linearen Mode arbeiten, wenn die gesamte Eingangsspannung kleiner als 0,9 Volt wird.

Zur Kopplung des Phasenregelkreises PLL mit dem spannungsgesteuerten Oszillator VCO ist ein weiterer Widerstand $R_{10}$ und eine Diode $D_4$ vorgesehen.

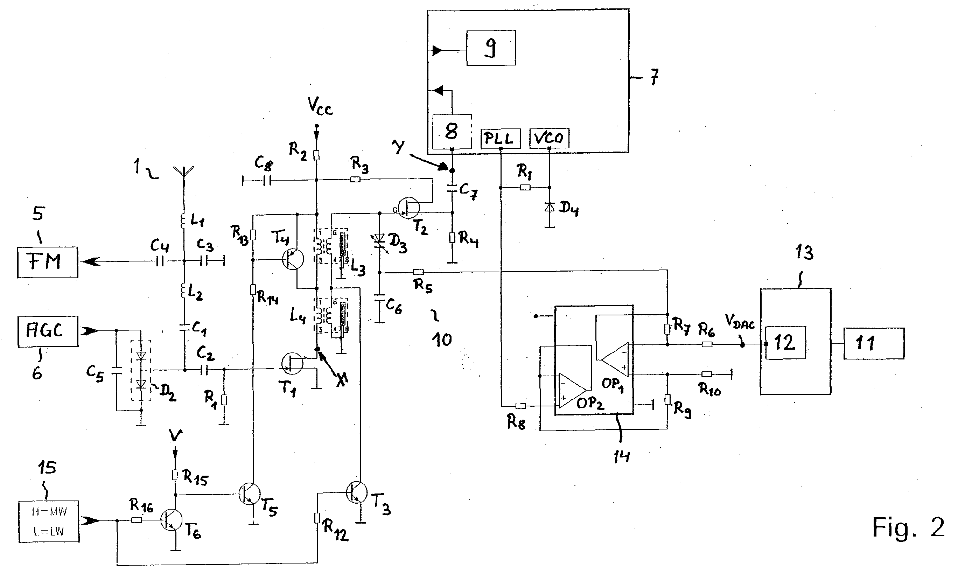

Die Figur 2 lässt das Schaltbild eines AM-Empfängers erkennen, der zusätzlich einen Empfang von Langwellen-Signalen (LW) ermöglicht. Hierzu ist ein weiterer Übertrager $L_4$ seriell jeweils mit der Primärseite und Sekundärseite des ersten Übertragers $L_3$ verbunden. Die Abstimmschaltung 10 selbst ist im Wesentlichen unverändert.

Die Sekundärwicklung des zweiten Übertragers $L_4$ ist über einen Schalttransistor $T_3$ abschaltbar, dessen Basis über einen Widerstand $R_{12}$ von einem binären Schaltsignal 15 angesteuert wird. Das binäre Schaltsignal 15 ist für Mittelwelle auf "High" und für Langwelle auf "Low" gesetzt. Weiterhin kann die Primärwicklung des ersten Übertragers $L_3$ durch einen Schalttransistor $T_4$ bei der Auswahl eines Langwellen-Signalempfangs überbrückt werden. Der Schalttransistor $T_4$ wird über einen Widerstand $R_{13}$ zwischen Emitter und Basis und ein Basiswiderstand $R_{14}$ von weiteren Schalttransistoren $T_5$ und $T_6$ angesteuert.

Bei der Auswahl eines Mittelwellen-Signals wird durch Anlegen eines "High"-Signals der Schalttransistor $T_3$ leitend und die Sekundärwicklung des zweiten Übertragers $L_4$ damit auf Massepotential gelegt. Der Schalttransistor $T_4$ hingegen ist nicht leitend, so dass das verstärkte Antennensignal über die Primärwicklungen der Übertrager $L_3$ und $L_4$ an die Sekundärwicklung des Übertragers $L_3$ übertragen wird.

Bei Auswahl eines Langwellen-Signals liegt "ein Low" Signal an der Basis der Schalttransistoren $T_6$ und $T_3$ an, die damit nicht leiten. Die Primärwicklungen der Übertrager $L_4$ und $L_3$ sind somit in Reihe wirksam. An der Basis des Schalttransistors $T_5$ liegt über den Widerstand $R_{15}$ eine Schaltspannung an, die dazu führt, dass der Schalttransistor $T_5$ leitet. Dann liegt an der Basis des Schalttransistors $T_4$ über den aus den Widerständen $R_2$, $R_{13}$ und $R_{14}$ gebildeten Spannungsteiler einen Anteil der Versorgungsspannung $V_{CC}$ an, wodurch der Schalttransistor $T_4$ leitet und die Primärwicklung des ersten Übertragers $L_3$ überbrückt. Die Auskopplung des verstärkten Antennensignals erfolgt somit über den zweiten Übertrager $L_4$ auf die Primärwicklung des zweiten Übertragers $L_4$.

**Patentansprüche**

1. AM-Empfänger für amplitudenmodulierte Rundfunksignale mit einer Antennensignalvorstufe (2) und einem Mischer (8) zur Umsetzung des Antennensignals von der Empfangsfrequenz auf eine höhere Zwischenfrequenz (ZF), **dadurch gekennzeichnet, dass** zwischen der Antennensignalvorstufe (2) und dem Mischer (8) eine Abstimmschaltung (10) vorgesehen ist, wobei die Abstimmschaltung (10) mit einer Abstimmspannung ($V_T$) in Abhängigkeit einer mit einem Digital-Analog-Wandler (12) aus für Empfangsfrequenzen definiert gespeicherten digitalen Werten gewonnenen analogen Steuerspannung ($V_{DAC}$) und einer Feldstärkemessspannung ($V_{PLL}$) angesteuert ist.

2. AM-Empfänger nach Anspruch 1, **dadurch gekennzeichnet, dass** die Abstimmspannung ($V_T$) proportional zur Differenz aus Feldstärkemessspannung ($V_{PLL}$) und analoger Steuerspannung ($V_{DAC}$) ist.

3. AM-Empfänger nach einem der vorhergehenden Ansprüche, **dadurch gekennzeichnet, dass** die Feldstärkemessspannung ($V_{PLL}$) eine Ausgangsspannung eines Phasenregelkreises (PLL) des AM-Empfängers ist.

4. AM-Empfänger nach einem der vorhergehenden Ansprüche, **dadurch gekennzeichnet, dass** die Abstimmschaltung (10) einen Übertrager ($L_3$) und eine kapazitive Abstimmdiode ($D_3$) hat, die zwischen die Sekundärwicklung des Übertragers ($L_3$) und einem Anschluss für die Abstimmspannung ($V_T$) geklemmt ist, so dass die Kapazität der Abstimmdiode ($D_3$) abhängig von der Abstimmspannung ($V_T$) ist.

5. AM-Empfänger nach einem der vorhergehenden Ansprüche, **dadurch gekennzeichnet, dass** die Sekundärwicklung des Übertragers ($L_3$) und eine Reihenschaltung aus Abstimmdiode ($D_3$) und Kapazität ($C_6$) parallel an Massepotential (GND) und an einen Verstärker ($T_2$) geschaltet sind und der Ausgang des Verstärkers ($T_2$) über eine Entkopplungskapazität ($C_7$) an den Mischer (8) geklemmt ist.

6. AM-Empfänger nach einem der vorhergehenden Ansprüche, **dadurch gekennzeichnet, dass** der Digital-Analog-Wandler (12) über einen ersten Widerstand ($R_6$) an einen ersten Eingang eines mit seinem Ausgang über einen zweiten Widerstand ($R_7$) an den ersten Eingang rückgekoppelten ersten Operationsverstärkers ($OP_1$) geschaltet ist, wobei am Ausgang des ersten Operationsverstärkers ($OP_1$) die Abstimmspannung ($V_T$) anliegt, und die Feldstärkemessspannung ($V_{PLL}$) an den ersten Eingang eines rückgekoppelten zweiten Operationsverstärkers ($OP_1$) gelegt und der Ausgang des rückgekoppelten zweiten Operationsverstärkers ($OP_2$) über einen Widerstand ($R_9$) an den zweiten Eingang des ersten Operationsverstärkers ($OP_1$) geklemmt ist.

7. AM-Empfänger nach Anspruch 1, **dadurch ge-**

**kennzeichnet, dass** die Abstimmspannung ($V_T$) proportional zum Verhältnis des zweiten Widerstandes ($R_7$) zum ersten Widerstand ($R_6$) ist.

8. AM-Empfänger nach einem der vorhergehenden Ansprüche, **gekennzeichnet durch** einen zweiten Übertrager ($L_4$) zum Empfangen eines anderen Frequenzbandes (LW), der mit seinen Primärund Sekundärwicklungen jeweils seriell an die entsprechende Primär- und Sekundärwicklung des ersten Übertragers ($L_3$) schaltbar ist.

Fig. 1

Fig. 2

EP 1 538 496 A2